# EUROPÄISCHE PATENTSCHRIFT

(11) **EP 1 348 971 B1**
(45) Veröffentlichungstag und Bekanntmachung des Hinweises auf die Patenterteilung: **20.07.2005**
(21) Anmeldenummer: 02007170.0
(22) Anmeldetag: 28.03.2002
(51) Int. Cl.: G01R 31/3185, G01R 31/316, G01R 31/04

(54) **Senderseitige Zusatzschaltung für den Boundary Scan bei der Datenübertragung mit differentiellen Signalen**
Additional output circuit for differential signal transmission during boundary scan
Circuit supplémentaire côté émetteur pour la transmission de données par signaux différentiels lors d'un "boundary scan"

(43) Veröffentlichungstag der Anmeldung: 01.10.2003
(73) Patentinhaber: SIEMENS AKTIENGESELLSCHAFT, 80333 München (DE)
(72) Erfinder: König, Wilhelm, 86391 Stadtbergen (DE); Parker, Heinz, 83700 Rottach-Egern (DE); Zettl, Gerhard, 85551 Kirchheim (DE)

(56) Entgegenhaltungen:
- EP-A- 0 810 446
- SOMA M: "Review of IEEE P1149.4 mixed-signal test bus standard" NORTHCON/96 SEATTLE, WA, USA 4-6 NOV. 1996, NEW YORK, NY, USA,IEEE, US, 4. November 1996 (1996-11-04), Seiten 320-323, XP010203000 ISBN: 0-7803-3277-6
- "IEEE standard for Low-Voltage Differential Signal (LVDS) for Scalable Coherent Interface (SCI)" IEEE STANDARD 1596.3-1996, XP002209441

## Beschreibung

Der Anmeldungsgegenstand betrifft eine Ausgangsschaltung für die differentielle Datenübertragung mit einem Leitungsabschluß zu einem Abschlußpotential.

Für die Prüfung der gelöteten Verbindungen zwischen verschiedenen Bausteinen ICs (Integrated Circuit) auf den Baugruppen wird in der Regel der sog. Boundary Scan verwendet. Boundary Scan (BSc) ist eine im Baustein integrierte Testlogik, die als Testhilfe für den Baustein- und Baugruppentest dient. Boundary Scan ist von IEEE standardisiert worden /1/: "IEEE Standard Test Access Port and Boundary-Scan Architecture, IEEE Std 1149.1-1990 (includes IEEE Std 1149.1a-1993), vom 21. Okt. 1993, herausgegeben vom IEEE Institute of Electrical and Electronics Engineers, Inc., New York". Die BSc-Architektur besteht aus einem Schieberegister (BSc-Register), das zwischen Anschlußpins und interner Logik so eingefügt ist, daß das Signal im Normalbetrieb durch einen zusätzlichen Multiplexer geführt wird.

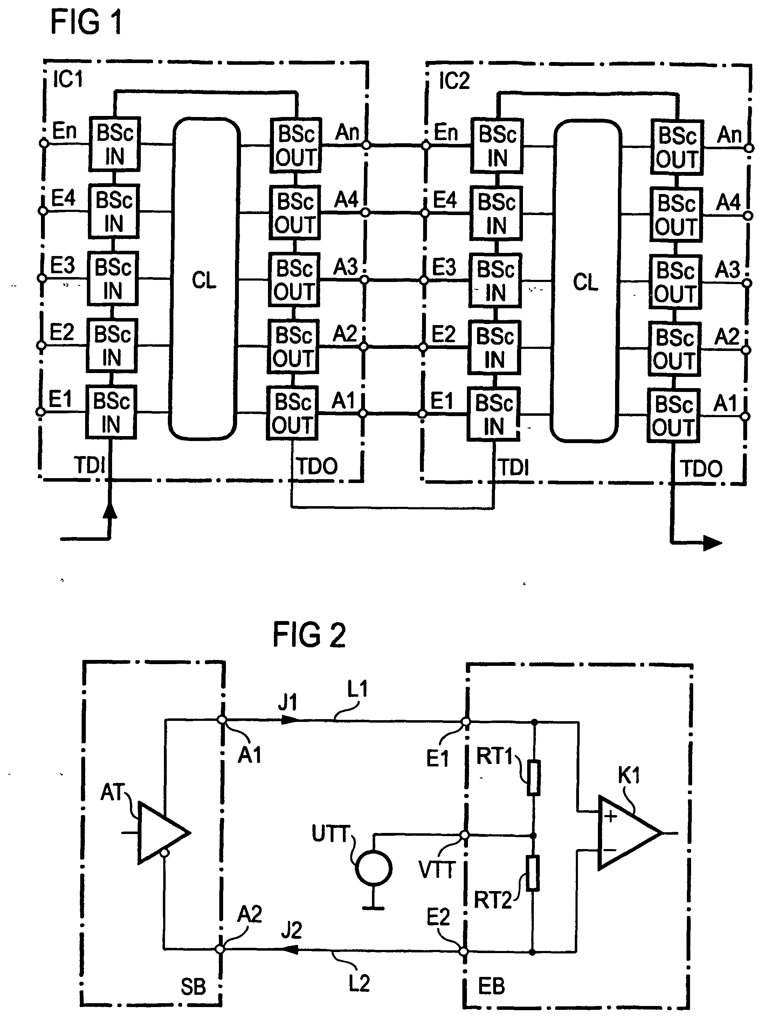

Fig 1 zeigt das Prinzip des Boundary Scan und die Anwendung beim Test von Verbindungsleitungen auf einer Baugruppe. Zwischen den Eingangspins E1 bis En und der Kernlogik CL (für: Core Logic) eines Bausteins IC1 (für: Integrated, Circuit) befinden sich die Boundary Scan-Eingangszellen BScIN und zwischen der Kernlogik und den Ausgangspins A1.1 bis An die Boundary Scan-Ausgangszellen BScOUT. Die BSc-Zellen BScIN und BScOUT bilden die einzelnen Speicherzellen des Schieberegisters. Das Schieberegister kann seriell über den Eingang TDI (test data in) oder parallel über die Eingangspins E1 bis En geladen werden, ebenso können die Ausgangsdaten seriell am Ausgang TDO (test data out) oder parallel an den Ausgängen A1.1 bis An ausgelesen werden. In Fig 1 ist als Beispiel der Test der Verbindungen zwischen den Ausgängen A1.1 bis An von IC1 und den Eingängen E1 bis En von Baustein IC2 gezeigt. Dazu wird über den Eingang TDI von IC1 ein Testbitmuster seriell in das Schieberegister eingeschoben, bis es in den BSc-Ausgangszellen BScOUT von IC1 steht, dann als paralleles Bitmuster an IC2 übertragen, dort von den BSc-Eingangszellen BScIN übernommen und seriell über das Schieberegister von IC2 am Ausgang TDO herausgeschoben , wo es dann vom Testsystem analysiert wird.

Fig 2 zeigt das Prinzip einer Datenübertragung mit differentiellen Leitungen. Der Sendebaustein SB mit der Ausgangstreiberstufe AT sendet an den Pins A1 und A2 zueinander komplementäre Signale, z.B. an A1 eine logische "1" und an A2 eine logische "0". Die Leitungen L1 und L2 sind am Empfängerbaustein EB jeweils mit einem Abschlußwiderstand RT1 bzw. RT2 an das Abschlußpotential VTT angeschlossen, das von einer Spannungsquelle UTT geliefert wird. Es sind auch differentielle Übertragungen ohne das Abschlußpotential möglich, so daß die Widerstände in Reihe geschaltet sind und zu einem zusammengefaßt werden können. Da bei den heute meistverwendeten CMOS-Technologien in der Regel die Ausgangsstufen beim Sendebaustein geschaltete Stromquellen und damit hochohmig sind, können aber bei fehlender Anbindung an ein Abschlußpotential eventuelle Gleichtaktstörungen schlecht bedämpft werden, so daß für schnelle Datenübertragungen meist die Variante mit Abschlußpotential zum Einsatz kommt. Eine solche Stromquelle liefert z.B. am Pin A1 den Strom J1, der an RT1 einen entsprechenden Spannungsabfall erzeugt, und zieht in den Pin A2 einen Strom J2, der an RT2 einen entsprechenden Spannungsabfall erzeugt. Der Eingangskomparator K1 detektiert die Spannungsdifferenz über RT1 und RT2. Beim komplementären Pegel kehren sich die Stromrichtungen um. (Anmerkung: Bei dem weiter unten beschriebenen LVDS (low voltage differential signalling)-Standard ist J2 = J1, so daß die Ausgangsstufe source- und sinkfähig ist. Bei dem ebenfalls weiter unten beschriebenen CML (current mode logic)-Standard ist die Ausgangsstufe nur source- oder sinkfähig - je nach schaltungstechnischer Realisierung - und es fließt nur in einer Leitung ein Strom, während die andere Leitung stromlos ist. Der Strom fließt dann über den Mittenabgriff C.)

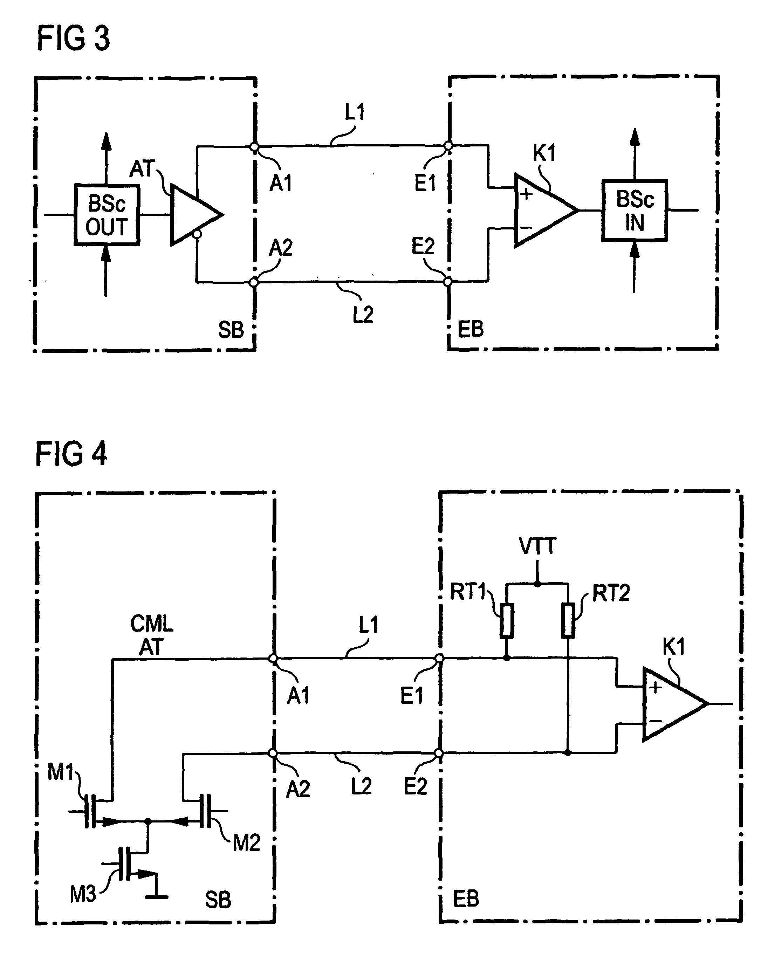

Bei CMOS-Bausteinen erfolgt die Verarbeitung der logischen Signale intern als Eintaktsignale, d.h. jedem Signal ist nur eine Leitung zugeordnet, deren Pegel auf ein Nullpotential (Masse) bezogen ist. Für die Übertragung von Baustein zu Baustein verwendet man bei hohen Datenraten jedoch meistens differentielle Signale. Um zu vermeiden, daß die Ein- und Ausgangsschaltungen, die die differentiellen Signale empfangen bzw. erzeugen, durch die zusätzliche Logik für den Boundary Scan belastet werden und die Qualität der übertragenen Signale somit beeinträchtigt wird, speist man die Daten im Boundary Scan-Betrieb sendeseitig vor dem Ausgangstreiber als Eintaktsignale ein und verarbeitet ebenso empfangsseitig die Daten nach dem Eingangsbuffer als Eintaktsignale weiter. Dies zeigt Fig 3; BScOUT ist die Boundary Scan-Zelle vor dem Ausgangstreiber, BScIN die entsprechende Zelle nach dem Eingangskomparator. Es können also nicht beide Leitungen eines differentiellen Signals auf Senderseite separat angesteuert und auf Empfangsseite separat ausgewertet und somit auch nicht beide Verbindungsleitungen auf der Baugruppe unabhängig voneinander geprüft werden.

Um trotzdem im Prüffeld beide differentiellen Leitungen prüfen zu können, wurden teilweise zusätzliche Prüfverfahren angewendet. Es wurden z.B. die betreffenden Leitungen auf der Baugruppe mit Nadeln kontaktiert, darauf Ströme eingeprägt und mit Hilfe von zusätzlichen Pins beim Sende- und/oder Empfangsbaustein der Spannungsabfall an den Eingangsschutzdioden, Eingangswiderstände usw. geprüft. Solche zusätzlichen Prüfverfahren verursachen aber hohe Kosten. Zudem setzt die Kontaktierung mit Nadeln voraus, daß die Leitungen an der Oberfläche der Baugruppe zugänglich sind. Bei den neuen Baugruppentechnologien kommen nun sog. µ-Vias zum Einsatz, d.h. die Durchkontaktierungen (Vias) zwischen Leitungen in verschiedenen Verdrahtungsebenen werden nicht wie bisher durch die ganze Baugruppe gebohrt, sondern nur noch zwischen den Ebenen, in denen diese Leitungen liegen. Besonders Leitungen für hochbitratige Verbindungen werden dann nur noch in innenliegenden, geschirmten Ebenen geführt, und, da bei den Bausteinen für hohe Bitraten bevorzugt Ball-Grid Array-Gehäuse zum Einsatz kommen, bei denen die Anschlüsse auf der Unterseite des Bausteins verlötet werden und somit ebenfalls nicht mehr zugänglich sind, besteht keine Möglichkeit mehr, diese Leitungen mit Nadeln zu kontaktieren.

Ist bei einer differentiellen Verbindung nach Fig 2 eine der beiden Leitungen unterbrochen, z.B. durch einen Haarriß oder nicht angelötete Pins bzw. Balls, so kann beim Boundary Scan diese Unterbrechung nicht eindeutig erkannt werden. Dies wird im Folgenden an Hand von Funktionsbeschreibungen von LVDS- und CML-Schaltungen näher erläutert.

Für die schnelle elektrische Datenübertragung zwischen Bausteinen auf einer Baugruppe oder über eine Rückwand auf eine andere Baugruppe haben sich verschiedene Interface-Standards herausgebildet wie ECL (emitter coupled logic), GTL (gunning transceiver logic), CML, LVDS usw. Bei diesen Standards sind jeweils die Spannungspegel bzw. Ausgangsströme, Abschlußwiderstände und ähnliches genormt. Die Ausgangsschaltungen des Sendebausteins arbeiten dabei häufig als geschaltete Stromquellen, die an den Abschlußwiderständen einen entsprechenden Spannungshub erzeugen, der sich bei diesen Standards in der Regel bei einigen hundert mV bewegt.

Bei hohen Datenraten und CMOS kommen vor allem LVDS (low voltage differential signaling) /2/ " IEEE Standard for Low-Voltage Differential Signals (LVDS) for Scalable Coherent Interface (SCI), IEEE Std 1596.3-1996, vom 31. Juli 1996, herausgegeben vom IEEE Institute of Electrical and Electronics Engineers, Inc., New York" und CML zum Einsatz. Die Funktionsweise von CML wird weiter unten beschrieben.

Bei LVDS-Verbindungen erfolgt beim Empfänger der Abschluß durch einen 100 Ω-Widerstand zwischen den differentiellen Leitungen, wobei dieser Widerstand häufig in zwei in Serie geschaltete Widerstände (mit je 50 Ω) aufgeteilt und der entstehende Mittenanschluß auf ein Festpotential von-VTT = 1, 2 V gelegt wird. Mit dieser Ankoppelung an das Festpotential kann man Gleichtaktstörungen auf den Leitungen wirksam bedämpfen. Diese Abschlußwiderstände sind bei modernen CMOS-Technologien in der Regel im Baustein integriert. Bei LVDS fließt beim Senden einer logischen "1" Strom vom Sender aus Pin A1 durch die Widerstände RT1 und RT2 zum Pin A2 des Senders zurück. Der Empfänger detektiert die Spannungsdifferenz an den Widerständen und der Eingangsbuffer wandelt sie wieder in logische Pegel um. Beim Senden einer logischen "0" kehrt sich die Stromrichtung und damit das Vorzeichen des Spannungsabfalls an RT1 und RT2 um.

Jetzt sei die Leitung L2 unterbrochen, z. B. durch einen Haarriß auf der Baugruppe oder durch einen nicht angelöteten Pin. Dann fließt im Fall einer logischen "1" der Ausgangsstrom über RT1 zur Spannungsquelle UTT von 1.2 V. An RT1 entsteht der gleiche Spannungsabfall wie vorher. An RT2 entsteht kein Spannungsabfall. Der Eingangskomparator erhält an seinem Eingang jetzt zwar nur den halben Hub, wird aber die "1" korrekt detektieren. Im Fall einer "0" am Senderausgang kehrt sich die Stromrichtung und damit das Vorzeichen des Spannungsabfalls an RT1 um; RT2 ist wieder stromlos. Vom Eingangskomparator wird die "0" korrekt detektiert. Es kann also hinter dem Eingangskomparator nicht erkannt werden, daß eine der beiden differentiellen Leitungen unterbrochen ist. Die differentielle Übertragung wird in diesem Fall auf eine Eintaktübertragung reduziert. Bei hohen Datenraten oder Taktfrequenzen entstehen dann wegen der verminderten Reserve Bitfehler.

Bei CML (Fig 4) ist je nach logischem Sendepegel entweder die eine oder andere Leitung stromführend, während die jeweils andere stromlos ist. An den Eingängen E1 und E2 sind die differentiellen Signalleitungen mit den Abschlußwiderständen RT1 und RT2 verbunden, deren andere Anschlüsse an ein gemeinsames Abschlußpotential VTT geführt sind. Dieses Abschlußpotential ist in vielen Fällen die Versorgungsspannung VDD des Bausteins. Es kann auch ein niedrigeres Abschlußpotential verwendet werden, z.B. um Verlustleistung zu sparen - in diesem Fall wird das Abschlußpotential über einen separaten Pin von außen zugeführt - oder um den Eingangsempfänger in einen optimalen Arbeitspunkt zu bringen - in diesem Fall kann das Abschlußpotential entweder im Baustein erzeugt oder über einen separaten Pin von außen zugeführt sein. Beim Senden einer logischen "1" sperrt Transistor M1 und an RT1 entsteht kein Spannungsabfall. M2 ist dann leitend und übernimmt den Strom des als Stromquelle geschalteten Transistors M3. Der Spannungsabfall an RT2 wird vom Eingangskomparator detektiert und wieder in eine logische "1" umgesetzt. Beim Senden einer logischen "0" leitet M1 und übernimmt den Strom von der Stromquelle M3, so daß an RT1 ein Spannungsabfall entsteht, der vom Eingangskomparator detektiert wird. M2 sperrt, so daß an RT2 kein Spannungsabfall entsteht.

Jetzt sei z.B. wieder Leitung L2 unterbrochen. Im Fall einer logischen "1" an A1 und einer "0" an A2 ist RT1 stromlos, aber auch RT2, da M2 zwar leitet, der Strom aber wegen der unterbrochenen Leitung nicht durch RT2 fließen kann. Der logische Pegel am Ausgang des Empfangskomparators hängt dann von seiner Offsetspannung ab, d.h. je nach deren Vorzeichen wird am Ausgang eine "0" oder "1" entstehen. Entsteht eine "1", so ist die gesendete "1" korrekt erkannt, trotz der unterbrochenen Leitung. Im Fall einer "0" am Ausgang A1 wird diese beim Empfänger richtig erkannt, da die stromführende Leitung nicht unterbrochen ist. Es hängt also bei CML von der Offsetspannung des Eingangskomparators ab, ob eine Leitungsunterbrechung erkannt wird oder nicht.

Aus der EP 0810446 ist eine Anordnung zur Signalübertragung über differentielle Leitungen bekannt, bei der zur Prüfung der einzelnen Leitungen auf der Empfangsseite die Leitung auf ein erstes oder zweites Prüfpotential gelegt werden muß.

Der Erfindung liegt das Problem zugrunde, bei differentiellen Verbindungen - z.B. nach dem LVDS-Prinzip mit Mittenanzapfung oder nach dem CML-Prinzip - ohne besondere Ausgestaltung der Empfangsseite eine Möglichkeit zu schaffen, eine Unterbrechung auch nur einer Verbindungsleitung eindeutig detektierbar zu machen.

Das Problem wird durch eine Ausgangsschaltung mit den Merkmalen des Anspruchs 1 gelöst.

Der Anmeldungsgegenstand bringt eine Prüfbarkeit von differentiellen Verbindungen mit eindeutigem Prüfergebnis mit sich ohne dass eine besondere Ausgestaltung der Empfangsseite notwendig ist.

Der Anmeldungsgegenstand wird im folgenden als Ausführungsbeispiel in einem zum Verständnis erforderlichen Umfang anhand von Figuren näher erläutert. Dabei zeigen:
Fig 1 eine prinzipielle Darstellung des Boundary Scan für zwei Bausteine IC1 und IC2,
Fig 2 das Prinzip einer Datenübertragung mit differentiellen Leitungen,
Fig 3 eine differentielle Datenübertragung zwischen CMOS-Bausteinen mit Boundary Scan,
Fig 4 eine CML-Verbindung zwischen CMOS-Bausteinen,
Fig 5 eine prinzipielle Darstellung einer Ausführungsform der Erfindung,
Fig 6 eine Ausführungsform der Zusatzlogik und
Fig 7 eine schaltungstechnische Realisierung eines Ausgangstreibers ZAT1 bzw. ZAT2.

In den Figuren bezeichnen gleiche Bezeichnungen gleiche Elemente.

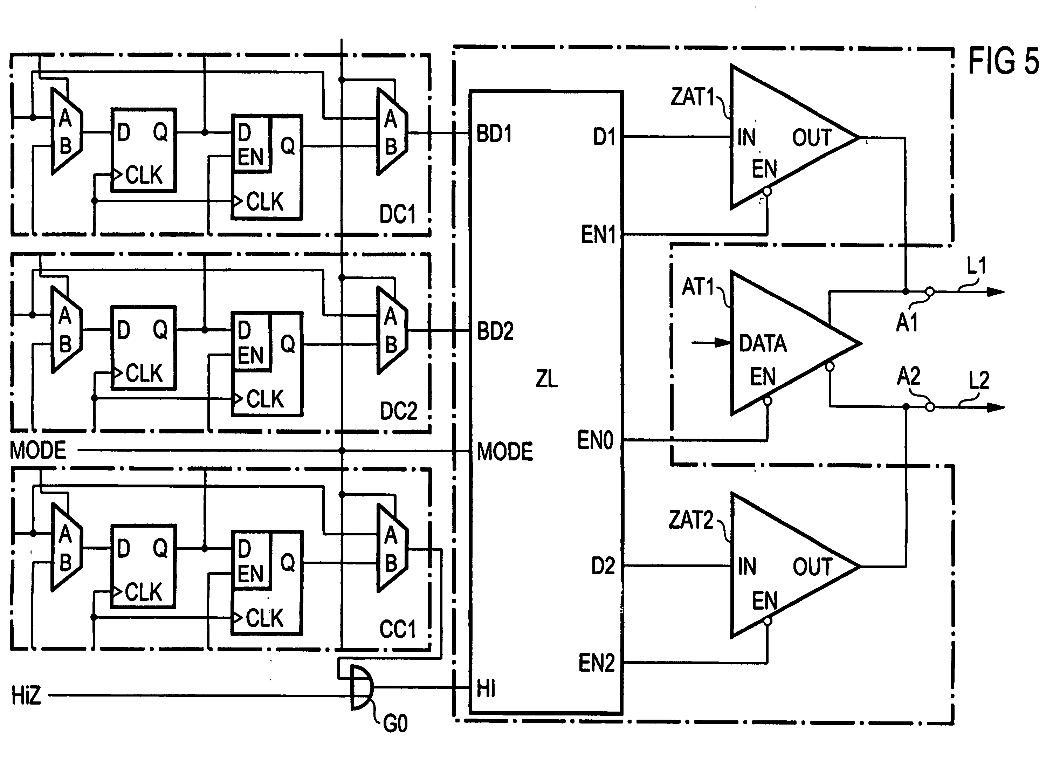

Fig 5 zeigt eine prinzipielle Ausführungsform der Erfindung. Es ist für einen eine Integrierte Schaltung aufnehmenden Baustein eine Zusatzschaltung vorhanden, die 2 Ausgangstreiber ZAT1 und ZAT2 und einer Zusatzlogik ZL umfasst. Die Ausgänge von ZAT1 und ZAT2 sind mit Leitung L1 bzw. L2 verbunden; die Ausgangsimpedanzen können über die Steuersignale EN1 bzw. EN2 auf hochohmig geschaltet werden. Solche Ausgangstreiber werden auch als Tristate-Buffer bezeichnet, der hochohmige Zustand auch als HiZ (high impedance). AT1 ist der Ausgangstreiber für die normale Übertragung von Daten DATA von der Kernlogik des Bausteins auf die Ausgänge A1 und A2. Sind die Ausgangstreiber ZAT1 und ZAT2 im hochohmigen Zustand, dann haben sie keinen Einfluß auf die Funktion.

Im BSc-Fall muß der Ausgangstreiber AT1 hochohmig, ZAT1 und ZAT2 dagegen aktiv sein. Die Zusatzlogik dient dazu, die Ausgangstreiber AT1, ZAT1 und ZAT2 zwischen dem Normalbetrieb und dem BSc-Fall geeignet umzuschalten. In Fig. 5 ist links das BSc-Register angedeutet; es umfasst die Datenzellen DC1 und DC2 (für: Data Cell). sowie die Kontrollzelle CC1 (für: Control Cell). Das BSc-Register, die Signale MODE und HiZ und das ODER-Gatter G0, welches das Ausgangssignal der Kontrollzelle CC1 mit dem Signal HiZ verknüpft, entsprechen der BSc-Spezifikation nach IEEE /1/.

Tabelle 1 zeigt die logischen Verknüpfungen für den Normalbetrieb und den Boundary-Scan bei der erfindungsgemäßen Ausgangsschaltung.

| DATA | MODE | Hl | BD1 | BD2 | EN0 | EN1 | EN2 | A1 | A2 | Bemerkung |
|---|---|---|---|---|---|---|---|---|---|---|
| 0 | 0 | 0 | x | x | 0 | 1 | 1 | 0 | 1 | Normalbetrieb |
| 1 | 0 | 0 | x | x | 0 | 1 | 1 | 1 | 0 | Normalbetrieb |
| x | 1 | 0 | 0 | 0 | 1 | 0 | 1 | 0 | Z | BSc |
| x | 1 | 0 | 1 | 0 | 1 | 0 | 1 | 1 | Z | BSc |
| x | 1 | 0 | 0 | 1 | 1 | 1 | 0 | Z | 1 | BSc |
| x | 1 | 0 | 1 | 1 | 1 | 1 | 0 | Z | 0 | BSc |
| x | x | 1 | x | x | 1 | 1 | 1 | Z | Z | BSc, Ausgänge hochohmig |
| x | 1 | x | x | x | 0 | x | x | x | x | unzulässig |
| Tabelle 1 (Z = hochohmig, x = irrelevant) | | | | | | | | | | |

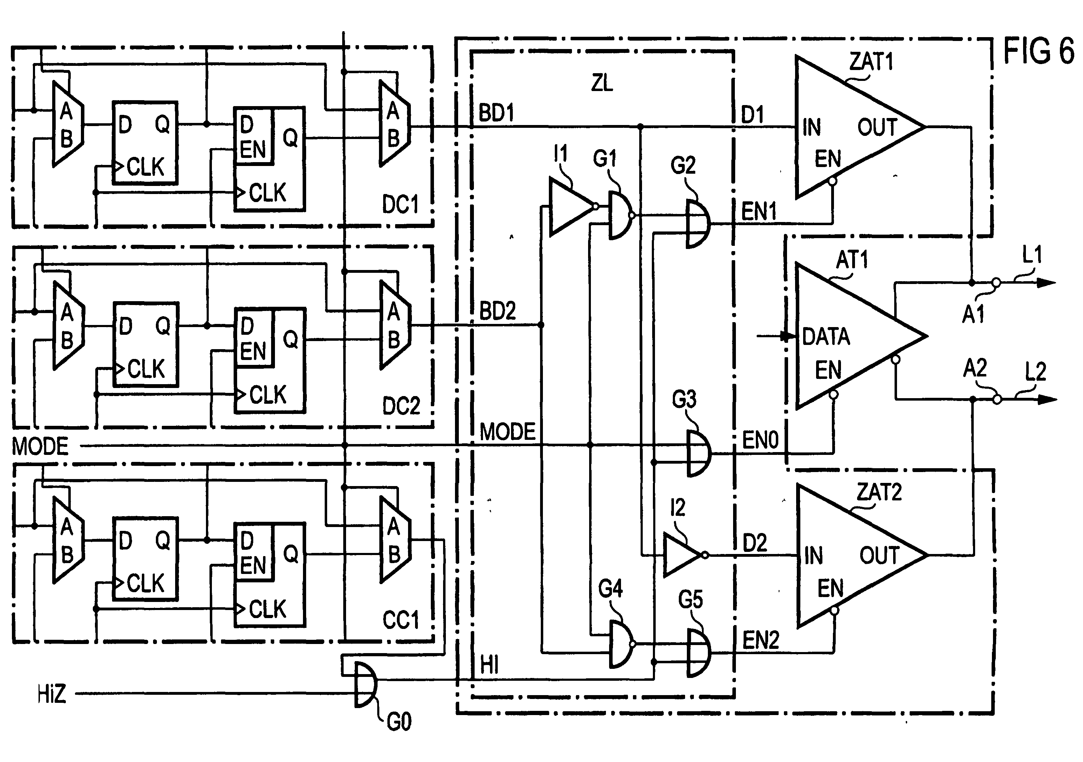

Das Signal MODE in Fig. 5 kommt von der Boundary Scan-Logik /1/. Wie sich aus Tabelle 1 ergibt, erfolgt die normale Datenübertragung von der Kernlogik zu den Ausgangspins, wenn sich MODE und HI jeweils auf logisch "0" befinden, so daß der Ausgangstreiber AT1 aktiviert ist, ZAT1 und ZAT2 dagegen hochohmig sind. Die Daten werden dabei komplementär auf die beiden Ausgangspins gegeben. Ist MODE "1" und HI "0", dann bestimmt die BSc-Logik die Daten an den Ausgangspins A1 und A2, da der Ausgangstreiber AT1 durch die Zusatzlogik hochohmig, dagegen jeweils der eine oder andere zusätzliche Ausgangstreiber aktiv wird und ein Datum auf die entsprechende Ausgangsleitung senden kann. Die Information, welcher von beiden gerade ausgewählt ist - ZAT1 oder ZAT2 - wird über eine der beiden Datenzellen geliefert, z.B. DC2 mit dem Signal BD2, vgl. auch Fig. 6. Über die andere Datenzelle, z.B. DC1 , wird mit dem Signal BD1 dann das an den Ausgang zu sendende Datum weitergegeben. Ist HI logisch "1", so sind die Ausgänge des Bausteins hochohmig, unabhängig von allen anderen Eingangssignalen. HI kann entweder über die Kontrollzelle CC1 oder mit dem Signal HiZ vom Befehlsregister der BSc-Logik auf "1" gesetzt werden. Diese ODER-Verknüpfung entspricht der BSc-Spezifikation nach IEEE /1/. Die Kombination MODE = "1" und EN0 = "0" in der letzten Zeile der Tabelle ist unzulässig, da dann im BSc-Fall auch der Ausgangstreiber AT aktiv wäre. Dies ist bei der Realisierung der Zusatzlogik zu beachten. Da lt. Spezifikation /1/ beim BSc die Daten nicht invertiert sein sollen, der Eingang E2 des Empfängers jedoch invertierend ist (vgl. Fig. 2, 3, 4), wird das Datum am Ausgang A2 invertiert ausgegeben, so daß insgesamt keine Invertierung stattfindet.

Die Prüfung auf Unterbrechung erfolgt für beide Leitungen L1 und L2 nacheinander, da für die differentiellen Signale am Empfangsbaustein nur ein einziger Komparator vorhanden ist, der das Differenzsignal detektiert, nicht aber zwei Eingangsempfänger wie bei unabhängigen Eintaktsignalen. Es sei beispielsweise die Leitung L1 zu prüfen. Dazu werden die Treiber AT1 und ZAT2 gemäß Fig 5 auf hochohmig gesetzt und Treiber ZAT1 wird abwechselnd auf "0" und "1" geschaltet. Folgt der Empfängerausgang diesem Wechsel, dann ist die Leitung in Ordnung, folgt er nicht, dann ist sie unterbrochen oder mit einer anderen Leitung kurzgeschlossen. Anschließend wird analog die gleiche Prüfung bei der Leitung L2 durchgeführt.

Fig 6 zeigt ein Ausführungsbeispiel für die erfindungsgemäße Zusatzschaltung. Die Zusatzlogik ZL mit den Gattern G1 bis G5 und den Invertern I1 und I2 realisiert die logische Verknüpfung entsprechend Tabelle 1. Die Umschaltung zwischen dem Normalbetrieb und dem BSc-Testfall kann auch durch andere schaltungstechnische Realisierungen erfolgen, z.B. mit UNDanstatt ODER-Gattern oder mit Hilfe von Multiplexern. Der Inverter I2 dient zur oben erwähnten Invertierung des Signals an Ausgang A2.

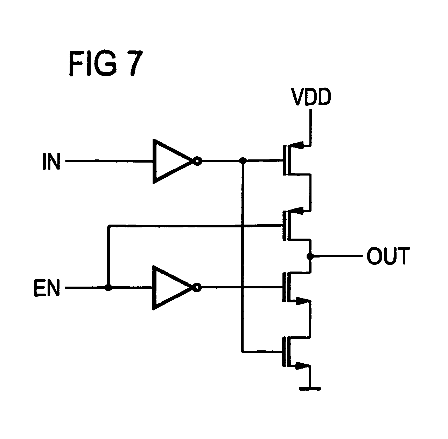

In Fig 7 ist ein Beispiel für die schaltungstechnische Realisierung eines Ausgangstreibers ZAT1 bzw. ZAT2 in CMOS-Technologie angegeben. Diese ist allgemein bekannt, z.B.: Marco Annaratone, "Digital CMOS Circuit Design", Kluwer Academic Publishers, 1986. ISBN 0-89838-224-6 /3/. Es sei noch darauf hingewiesen, daß ZAT1 und ZAT2 nur einen relativ geringen Strom liefern müssen, da sich am Eingang des Empfangsbausteins in der Regel ein empfindlicher Komparator zur Detektierung der Eingangssignale befindet. Es kann also z. B. aus der jeweiligen Gatterbibliothek des Halbleiterherstellers ein sehr kleiner Treiber gewählt werden, so daß am Ausgang nur eine geringe zusätzliche Kapazität wirksam ist, die die erreichbare Übertragungsgeschwindigkeit nur unwesentlich verringert.

An den Ausgängen des Sendebausteins können auch - analog zu den Eingängen eines Empfangsbausteines - Abschlußwiderstände für die Leitungen vorhanden sein, ohne daß dadurch die Funktion der erfindungsgemäßen Schaltungsanordnung beeinträchtigt wird. Diese Abschlußwiderstände können sowohl im Baustein integriert sein als auch sich außerhalb des Bausteins auf der Baugruppe befinden.

## Patentansprüche

1. Ausgangsschaltung für die differentielle Datenübertragung mit einem Leitungsabschluß zu einem Abschlußpotential, bei der
- eine Zusatzlogik (ZL)und an jeder der beiden differentiellen Leitungen ein zusätzlicher Ausgangstreiber (ZAT1, ZAT 2) vorhanden sind,
- mit der Zusatzlogik in einem Prüffall der Ausgangstreiber (AT1), der im Betriebsfall zur Datenübertragung dient, auf hochohmig schaltbar ist und gleichzeitig jeweils einer der beiden zusätzlichen Ausgangstreiber, deren Ausgänge jeweils mit einer der differentiellen Leitungen verbunden sind, aktivierbar ist,
- mit diesen zusätzlichen Ausgangstreibern Signale auf jede einzelne der differentiellen Leitungen übertragbar sind, die an dem der Ausgangsschaltung abgewandten Ende der differentiellen Leitungen derart auswertbar sind, daß eine Unterbrechung wenigstens einer der Leitungen erkannt wird.

## Claims

1. Output circuit for the differential transmission of data with a line termination to a termination potential, in the case of which
- there is an additional logic (ZL) and at each one of the two differential lines there is also an additional output driver (ZAT1, ZAT 2),
- with the additional logic in a test case, the output driver (AT1) which serves to transmit data in operating cases, can each time be switched to the high-impedance state and at the same time one of the two additional output drivers whose outputs are in each case connected to one of the differential lines can be activated,
- with these additional output drivers, signals can be transmitted to each one of the individual differential lines which, at the end of the differential lines facing away from the output circuit, can be evaluated in such a way that an interruption of at least one of the lines is detected.

## Revendications

1. Circuit de sortie pour la transmission de données différentielle comprenant une terminaison de ligne sur un potentiel de terminaison, dans lequel
- une logique supplémentaire (ZL) est présente ainsi que, au niveau de chacune des deux lignes différentielles, un circuit d'attaque de sortie supplémentaire (ZAT1, ZAT2),
- en mode test, la logique supplémentaire permet de commuter le circuit d'attaque de sortie (AT1) qui, en mode de fonctionnement, sert à la transmission de données, de manière à ce qu'il soit à l'état de haute impédance, et permet en même temps d'activer à chaque fois un des deux circuits d'attaque de sortie supplémentaires dont les sorties sont reliées à chaque fois à une des lignes différentielles,
- ces circuits d'attaque de sortie supplémentaires permettent de transmettre, sur chacune des lignes différentielles individuelles, des signaux qui peuvent être évalués au niveau de l'extrémité des lignes différentielles éloignée du circuit de sortie de manière à ce qu'une interruption d'au moins une des lignes soit détectée.
